# EUROPEAN PATENT APPLICATION

(11) **EP 4 745 788 A1**
(43) Date of publication of application: **20.05.2026**
(21) Application number: 25214983.6
(22) Date of filing: 11.11.2025
(51) Int. Cl.: G06F 12/06, G11C 7/10

(54) **METHOD AND APPARATUS WITH PROCESSING-IN-MEMORY COMPUTATION ADDRESS GENERATION**

(30) Priority: 14.11.2024 KR 20240162156
(71) Applicant: Samsung Electronics Co., Ltd., Suwon-si, Gyeonggi-do 16677 (KR)
(72) Inventor: Cha, Sanghoon, 16678 Suwon-si, Gyeonggi-do (KR); Paik, Yoonah, 16678 Suwon-si, Gyeonggi-do (KR); Kim, Hyunsoo, 16678 Suwon-si, Gyeonggi-do (KR); Lee, Sunjung, 16678 Suwon-si, Gyeonggi-do (KR); Choi, Minjeong, 16678 Suwon-si, Gyeonggi-do (KR)
(74) Representative: Grünecker Patent- und Rechtsanwälte PartG mbB

(57) **Abstract**

A processor-implemented method including generating a memory request related to a processing-in-memory (PIM) operation, obtaining a PIM computation address in response to the memory request, transmitting, to a memory controller, the memory request and the PIM computation address, and designating, by the memory controller, a memory address through bank shuffling, the bank shuffling mapping the PIM computation address to a set of addresses shuffled to a preset target bank.

## Description

### BACKGROUND

### 1. Field

The following description relates to a method and apparatus with processing-in-memory (PIM) computation address generation.

### 2. Description of Related Art

With the recent rapid increase in the volume and speed of data processing, various technologies are being studied to maximize data processing performance. Among them, processing-in-memory (PIM) technology has gained attention as key technology that processes data directly within a memory, reducing bottlenecks that occur from data transmission taking place between a central processing unit (CPU) and the memory, thereby improving data processing speed. This technology is becoming increasingly important, particularly in application fields that require large-scale data processing or real-time analysis.

In typical computing systems, the CPU reads data from memory to perform computations and then writes the results back to the memory. However, this approach may lead to performance degradation due to frequent data transmission between the CPU and the memory. To address this issue, PIM technology directly processes data within the memory itself, minimizing data transmission, reducing bottlenecks, and enhancing the overall efficiency of the system.

PIM technology may be applied to various fields, and methods to maximize the efficiency of in-memory computations are continuously being studied to enable its implementation. In particular, technologies for managing the position of data within a memory and optimizing parallel processing across multiple banks are factors that affect the performance of PIM computations.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is what is claimed in the independent claims. Preferred embodiments are specified in the dependent claims.

In a general aspect, here is provided a processor-implemented method including generating a memory request related to a processing-in-memory (PIM) operation, obtaining a PIM computation address in response to the memory request, transmitting, to a memory controller, the memory request and the PIM computation address, and designating, by the memory controller, a memory address through bank shuffling, the bank shuffling mapping the PIM computation address to a set of addresses shuffled to a preset target bank.

The obtaining of the PIM computation address may include obtaining the PIM computation address from a table storing the PIM computation address.

The table may store a row address from which the target bank is output in response to the designating.

The table may store a pair of a row address, from which the target bank is output in response to the designating, and a bank address corresponding to the row address.

The obtaining of the PIM computation address may include calculating a row address, based on a hash function used for the bank shuffling, from which the target bank is output by performing the bank shuffling.

The obtaining of the PIM computation address may include calculating a pair of a row address based on a dynamic random access memory (DRAM) addressing hash function used in the bank shuffling, from which the target bank is output, and a bank address corresponding to the row address by performing the bank shuffling.

The method may include changing, by the memory controller, a bank address of the PIM computation address to the target bank through the bank shuffling and generating a memory command including the PIM computation address changed through the bank shuffling and the memory request.

The method may include determining whether the changed PIM computation address included in the memory command corresponds to any one of predetermined designated memory addresses and, in response to the changed PIM computation address corresponding to any one of the designated memory addresses, converting, based on mapping information stored in a routing register, the changed PIM computation address to a redirected memory address mapped to the corresponding designated memory address.

The mapping information may map each of the designated memory addresses representing a partial region of a memory to a redirected memory address representing another partial region of the memory and the memory command may be executed in the converted redirected memory address.

In response to PIM operations for a target PIM tile corresponding to the converted redirected memory address being performed, a plurality of redirected memory addresses stored in the routing register may be updated to a plurality of redirected memory addresses corresponding to a PIM tile subsequent to the target PIM tile.

The bank shuffling may include shuffling of one of a bank or a channel.

In a general aspect, here is provided an electronic device including processors configured to execute instructions and a memory storing the instructions, and an execution of the instructions configures the processors to generate a memory request related to a processing-in-memory (PIM) operation, obtain a PIM computation address in response to the memory request, transmit, to a memory controller, the memory request and the PIM computation address, and designate, by the memory controller, a memory address through bank shuffling, the bank shuffling mapping the PIM computation address to a set of addresses shuffled to a preset target bank.

The processor may be further configured to obtain the PIM computation address from a table storing the PIM computation address.

The table may store a row address from which the target bank is output in response to the designating.

The table may store a pair of a row address, from which the target bank is output in response to the designating, and a bank address corresponding to the row address.

The processor may be further configured to calculate a row address, based on a hash function used for the bank shuffling, from which the target bank is output by performing the bank shuffling.

The processor may be further configured to calculate a pair of a row address, based on a dynamic random access memory (DRAM) addressing hash function used in the bank shuffling, from which the target bank is output by performing the bank shuffling, and a bank address corresponding to the row address.

The memory controller is configured to change a bank address of the PIM computation address to the target bank by performing the bank shuffling and generate a memory command including the PIM computation address changed through the bank shuffling and the memory request.

The processor may be further configured to determine whether the changed PIM computation address included in the memory command corresponds to any one of preset designated memory addresses and, in response to the changed PIM computation address corresponding to any one of the designated memory addresses, convert, based on mapping information stored in a routing register, the changed PIM computation address to a redirected memory address mapped to the corresponding designated memory address.

The mapping information may map each of the designated memory addresses representing a partial region of a memory to a redirected memory address representing another partial region of the memory and the memory command may be executed in the converted redirected memory address.

In response to PIM operations for a target PIM tile corresponding to the converted redirected memory address being performed, a plurality of redirected memory addresses stored in the routing register may be updated to a plurality of redirected memory addresses corresponding to a PIM tile subsequent to the target PIM tile.

### BRIEF DESCRIPTION OF THE DRAWINGS

FIG. 1 illustrates an example method with memory bandwidth including bank interleaving according to one or more embodiments.
FIG. 2 illustrates an example method of resolving a bank thrashing issue through bank shuffling and maximizing bank parallelism according to one or more embodiments.
FIG. 3 illustrates an example electronic device according to one or more embodiments.
FIG. 4 illustrates an example method of designating a row address as a processing-in-memory (PIM) computation address according to one or more embodiments.
FIG. 5 illustrates an example method of storing row addresses in a table according to one or more embodiments.
FIG. 6 illustrates an example method of designating, as a PIM computation address, a pair of a row address and a bank address corresponding to the row address according to one or more embodiments.
FIG. 7 illustrates an example method of storing pairs of row addresses and bank addresses in a table according to one or more embodiments.
FIG. 8 illustrates an example electronic device according to one or more embodiments.
FIGS. 9 and 10 illustrate examples routing tables according to one or more embodiments.
FIG. 11 illustrates an example method of operating an electronic device according to one or more embodiments.
FIG. 12 illustrates an example electronic device according to one or more embodiments.

Throughout the drawings and the detailed description, unless otherwise described or provided, it may be understood that the same drawing reference numerals refer to the same elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order, e.g., a certain order. Also, descriptions of features that are known after an understanding of the disclosure of this application may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Throughout the specification, when a component or element is described as being "on", "connected to," "coupled to," or "joined to" another component, element, or layer it may be directly (e.g., in contact with the other component or element) "on", "connected to," "coupled to," or "joined to" the other component, element, or layer or there may reasonably be one or more other components, elements, layers intervening therebetween. When a component or element is described as being "directly on", "directly connected to," "directly coupled to," or "directly joined" to another component or element, there can be no other elements intervening therebetween. Likewise, expressions, for example, "between" and "immediately between" and "adjacent to" and "immediately adjacent to" may also be construed as described in the foregoing.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

The examples may be implemented as various types of products, such as, for example, a personal computer (PC), a laptop computer, a tablet computer, a smartphone, a television (TV), a smart home appliance, an intelligent vehicle, a kiosk, and a wearable device. Hereinafter, examples will be described in detail with reference to the accompanying drawings. In the drawings, like reference numerals are used for like elements.

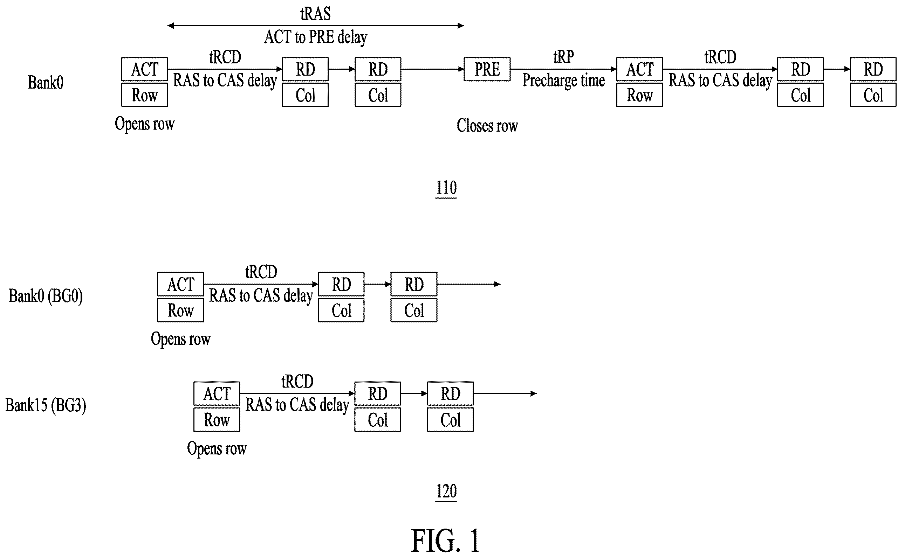

FIG. 1 illustrates an example method with memory bandwidth including bank interleaving according to one or more embodiments.

Referring to FIG. 1, in a non-limiting example, a diagram 110 illustrates a memory access process by row activation in a single bank of a memory. The memory access process may be performed in a way of activating a row first through ACT (a row activation command), waiting for row to column delay (tRCD), and reading data from a column address. In this case, data read commands may occur consecutively multiple times, with column address strobe (CAS) latency between each command. Ultimately, after all the data from the activated row is read, a PRE (a precharge command) may be issued to close the row, and a system may wait for the next command during the tRP (row precharge time). Through this process, data access in the first bank is completed.

On the other hand, in an example, a diagram 120 illustrates row activation and data access through bank parallelism. While data access is in progress in the first bank, row activation and a data access preparation process may be performed in parallel with another bank. For example, while a row is activated and data is read in a bank 0, each row may be activated and data access may be performed in the same way in a bank 15. In this way, bank parallelism may be utilized to the maximum, and row activation times and data reading times occurring in each bank may be efficiently distributed.

While a memory system reads and writes data only in one bank, a plurality of banks process data in parallel, thereby maximizing a memory bandwidth. For example, when all memory access occurrences are performed within a single bank (e.g., Bank 0), memory resources may be used inefficiently, as the row has to be closed after a single occurrence of row activation and data read, followed by waiting for the next command. However, as illustrated in the diagram 120, when row activation is performed simultaneously in other banks while row activation and data read are performed in Bank 0, the processing performance of the overall system may be significantly improved.

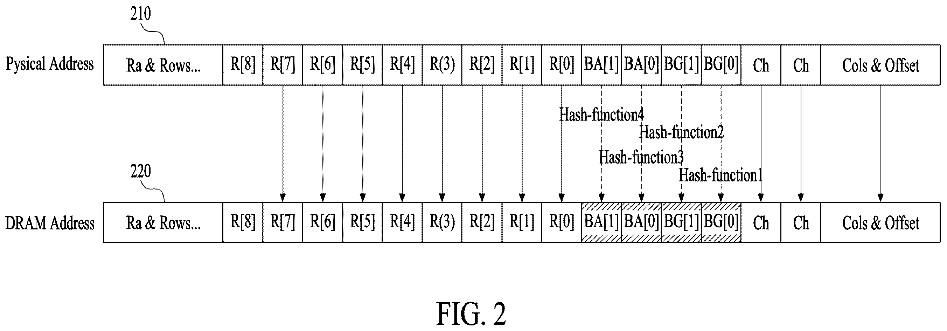

FIG. 2 illustrates an example method of resolving a bank thrashing issue through bank shuffling and maximizing bank parallelism according to one or more embodiments.

Bank thrashing may be an issue in which memory access time is slowed down because row activations occur frequently in the same bank. To prevent this issue, a memory controller may distribute memory requests evenly by performing an addressing function computation to randomly mix bank addresses. The addressing function computation may include a dynamic random access memory (DRAM) addressing function computation. For example, the addressing function computation may include bank shuffling, channel shuffling, and rank shuffling, but examples are not limited thereto.

Referring to FIG. 2, in a non-limiting example, the memory controller may shuffle bank addresses by applying a hash function between a physical address 210 and a DRAM address 220. More particularly, when a memory request is received, a bank address included in the physical address 210 may be input to an exclusive or (XOR) scheme hash function. The hash function may randomly convert a bank address by combining a row bit to a bank bit (e.g., a bank address bit and a bank group bit) to perform an XOR computation. A bank address shuffled in this way may be used as an actual target bank, and accordingly may prevent memory requests from focusing only on the same bank.

For example, bank addresses BA[0], BA[1], BG[0], and BG[1] of the physical address 210 may be shuffled together with a plurality of row bits through an XOR computation. As a result, BG and BA addresses may be randomly mixed. Converted bank addresses may be transmitted to the DRAM address 220, enabling distributed memory access across multiple banks.

In this process, a bank shuffling technique may resolve an issue that bank parallelism may not be utilized due to consecutive occurrences of access to the same bank when a memory access pattern uses a predetermined pattern such as a stride pattern. In other words, the bank shuffling technique may enable the memory controller to distribute data across multiple banks, allowing row activation to occur simultaneously in many banks, thereby maximizing bank parallelism. This process may optimize a memory bandwidth and may reduce memory access times.

However, when applied to a processing-in-memory (PIM) system, the bank shuffling technique may incur several issues. That is, when a multi-bank mode is used in the PIM system, an unexpected error may occur since many banks are activated simultaneously.

More particularly, while a PIM operation performs a computation by accessing one bank in general, the PIM system may execute the same command simultaneously in all banks. In other words, a PIM operation may require memory requests to access the same bank to perform a computation. A problem may occur when bank shuffling is performed, and that consecutive memory requests may be transmitted to different banks, which may cause a situation in which the memory controller transmits the next PIM command at a time that is out of sync with the expected timing. In this case, when a new command arrives even though the previously executing PIM operation is not completed, an error fatal to the PIM operation may occur. This error may cause a PIM operation to stop or lead to inconsistencies in computation results, which may seriously affect the performance and reliability of the entire system.

To solve this issue, a method of operating PIM by deactivating the bank shuffling function may be used. However, this method may prevent the utilization of bank parallelism, which may improve performance when general DRAM access is performed. In other words, when this method is followed, the PIM may operate normally, but the opportunity to reduce memory access latency may be missed.

Therefore, a method of linking a PIM operation to bank shuffling may be desired where the PIM operation and a bank shuffling technique do not conflict with each other. As described in greater detail below, a host system may predict bank addresses required for a PIM operation in advance and perform bank shuffling to prevent PIM system performance degradation and may also effectively utilize bank parallelism to optimize memory access time.

An example method of solving a bank conflict issue and maximizing bank parallelism through bank shuffling is described with reference to FIG. 2, but examples are not limited thereto. For example, examples may also apply to channel shuffling and rank shuffling. Channel shuffling is a technique that maximizes parallel processing by distributing data across multiple memory channels. When a PIM computation is performed, a memory channel has to be selected for a predetermined computation. In this case, randomly shuffling channel addresses using a hash function may reduce bottlenecks in data access and distribute data evenly across various channels. When a PIM computation requires data distributed across multiple ranks, computation requests may be evenly distributed through rank shuffling. This enables parallel access between ranks, and a memory bandwidth may expand through rank shuffling. Additionally, data access may be optimized to avoid overloading predetermined ranks during PIM computations.

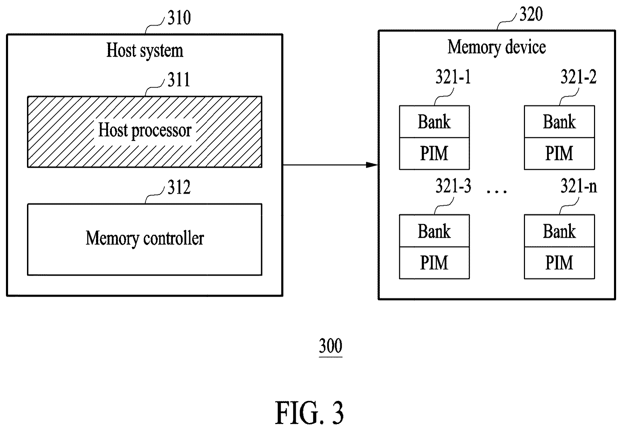

FIG. 3 illustrates an example electronic device according to one or more embodiments.

Referring to FIG. 3, in a non-limiting example, an electronic device 300 may include a host system 310 and a memory device 320. The host system 310 may include a host processor 311 and a memory controller 312. The memory device 320 may include a plurality of memory banks and a plurality of PIM blocks. For example, the memory device 320 may include a plurality of pairs of memory banks and PIM blocks 321-1, 321-2, 321-3, ..., 321-n. Although a single memory bank is illustrated as being mapped to a single PIM block in FIG. 3, this is only an example, and examples are not limited thereto. For example, a single PIM block may be mapped to a plurality of memory banks.

In an example, the host processor 311 may be a device configured to control the overall operation of the host system 310 and may include various processors, for example, a central processing unit (CPU), a graphics processing unit (GPU), a neural processing unit (NPU), a tensor processing unit (TPU), or a digital signal processor (DSP). The host processor 311 may generate a request for components (e.g., the memory controller 312) in the host system 310 and components in the memory device 320 via a host program.

The request for the memory device 320, generated by the host processor 311, may be related to a general memory operation and a PIM operation. The general memory operation may be a general operation (e.g., read, write, copy, and erase) of the memory device 320 and may be referred to as a non-PIM operation. The PIM operation may include one or more of arithmetic computations, such as addition, multiplication, and accumulation, and logical computations, such as AND, OR, and XOR, in the memory device 320. Without a need to read a large amount of operand data from the memory device 320 through a PIM operation to the host processor 311 and/or an accelerator, only a computation result may be read to the host processor 311 and/or the accelerator after a computation is directly performed in the memory device 320. Accordingly, power consumption may be minimized by reducing a data movement distance and minimizing the loss of a memory bandwidth.

In an example, the accelerator may be a device that operates according to the control of the host processor 311 and may process tasks that are more efficiently processed in a separate, dedicated processor (that is, the accelerator) rather than a general-purpose host processor 311 due to the nature of computations (e.g., computations according to a neural network or operations for a lot of operands). For example, the accelerator may include a GPU, an NPU, a TPU, a DSP, and the like.

In an example, the host processor 311 may generate a memory address together with a memory request. The memory request generated by host processor 311 may therefore be related to a memory address generated together with the memory request. The host processor 311 may transmit the generated memory request and the memory address to the memory controller 312.

The host processor 311 may generate or collect a PIM computation address. A PIM computation address is an address indicating a predetermined position in a memory to perform a PIM operation and a bank and a row of the memory that stores data requiring a PIM computation. A PIM computation address may designate a predetermined bank and a row of the memory in which data required for a computation is positioned when data is processed in a memory, thereby seamlessly performing a PIM computation.

In an example, the PIM computation address may be calculated using a reverse hash function. The PIM computation address may be managed by a lookup table, which is dynamically generated or predefined, and may be configured to process data in parallel across multiple banks. In other words, the host processor 311 may dynamically generate or collect a PIM computation address and accordingly transmit a command to the memory controller 312. When the PIM computation address is used while a PIM operation is performed, even though the memory controller 312 performs bank shuffling, a PIM computation address may be properly mapped to a predetermined bank.

In an example, the memory controller 312 may be a device for managing the flow of data input to or output from the memory device 320. The memory controller 312 may generate a memory command according to the memory request and the memory address received from the host processor 311 and may transmit the memory command to the memory device 320. The memory controller 312 may perform bank shuffling. The memory controller 312 may transmit the generated memory command to the memory device 320. The memory command may be related to an operation to be executed in the memory address in the memory.

In an example, the memory device 320 may be a device for performing a PIM operation through an internal processor which may be an operating other than storing data and may include, for example, DRAM, high bandwidth memory (HBM), graphics double data rate (GDDR), and low-power double data rate (LPDDR). However, examples are not limited thereto. The memory device 320 may be a hardware device capable of performing a PIM operation in addition to a general memory operation, and for example, may perform various computations since the memory device 320 is programmable. The memory device 320 may include a data storage space for storing data and an internal processor for performing the logical calculation and/or the arithmetic calculation as described above. The PIM operation may use the data storage space and the internal processor. The general memory operation may use the data storage space but may not use the internal processor.

The memory device 320 may store data by dividing an area into a channel, a bank, or a rank. The bank of the memory device 320 may be managed by the memory controller 312. The PIM operation may be performed on the data of one or more banks of the memory device 320.

The electronic device 300 may include various computing devices, such as a mobile phone, a smartphone, a tablet PC, an e-book device, a laptop, a PC, a desktop, a workstation, or a server, various wearable devices, such as a smart watch, smart eyeglasses, a head-mounted display (HMD), or smart clothing, various home appliances such as a smart speaker, a smart TV, or a smart refrigerator, and other devices, such as a smart vehicle, a smart kiosk, an Internet of things (IoT) device, a walking assist device (WAD), a drone, or a robot.

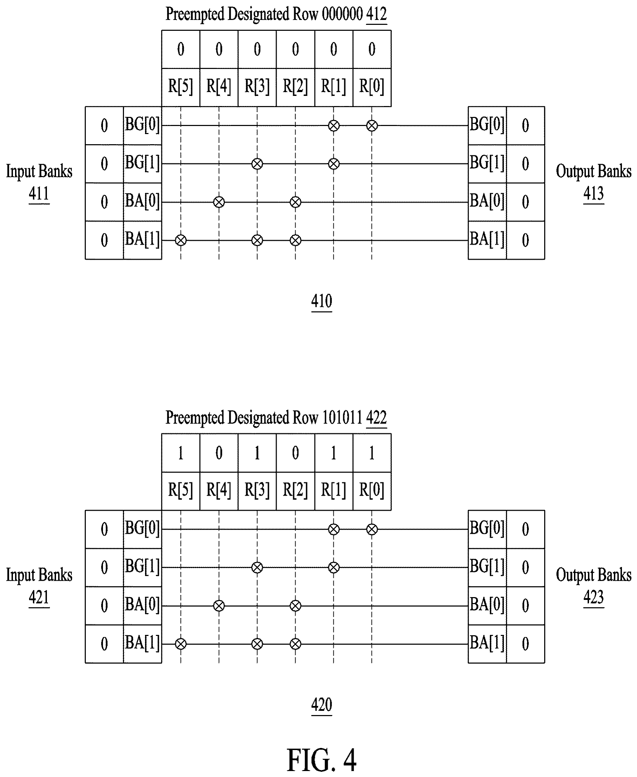

FIG. 4 illustrates an example method of designating a row address as a processing-in-memory (PIM) computation address according to one or more embodiments. The description provided with reference to FIG. 3 may also apply to FIG. 4.

Referring to FIG. 4, in a non-limiting example, a bank address of a PIM computation address is set as a predetermined target bank, and a host processor (e.g., the host processor 311 of FIG. 3) may calculate row bits suitable for the target bank address through a hash function and reserve the resulting row addresses.

In a case 410, the host processor may desire to obtain an output bank 413 of which bank addresses BG[0], BG[1], BA[0], and BA[1] all have 0 as a result of bank shuffling during a PIM operation. In this case, addresses BG[0], BG[1], BA[0], and BA[1] of an input bank 411 may all be fixed to 0. The host processor may calculate a row address that may output the output bank 413 through a hash computation with the input bank 411. In the case 410, an address 00000 412 from row bits R[0] to R[5] may be selected.

Similarly, in a case 420, the host processor may desire to obtain an output bank 423 of which bank addresses BG[0], BG[1], BA[0], and BA[1] all have 0 as a result of bank shuffling during a PIM operation. In this case, addresses BG[0], BG[1], BA[0], and BA[1] of an input bank 421 may all be fixed to 0. The host processor may calculate a row address that may output the output bank 423 through a hash computation with the input bank 421. In the case 420, an address 101011 422 from row bits R[0] to R[5] may be selected.

The host processor may reserve a row bit suitable for a target bank required for a PIM computation and prepare for efficiently performing the computation. Accordingly, the host processor may minimize an issue that may occur in bank shuffling.

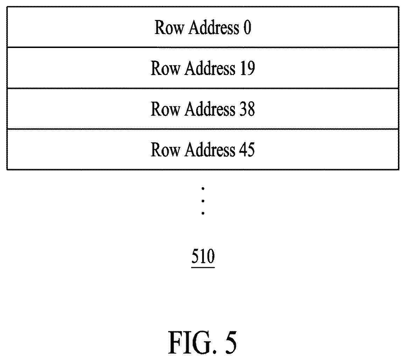

FIG. 5 illustrates an example method of storing row addresses in a table according to one or more embodiments. The description provided with reference to FIGS. 3 and 4 may also apply to FIG. 5.

Referring to FIG. 5, in a non-limiting example, a table 510 may store row addresses required for a PIM computation in advance (i.e., reserved) and may be utilized as a lookup table for a computation whenever necessary. For example, Row Address 0, Row Address 19, Row Address 38, and Row Address 45 may be stored as PIM computation addresses in the table 510. A host processor (e.g., the host processor 311 of FIG. 3) may enhance efficiency in performing a PIM computation through row addresses stored in advance.

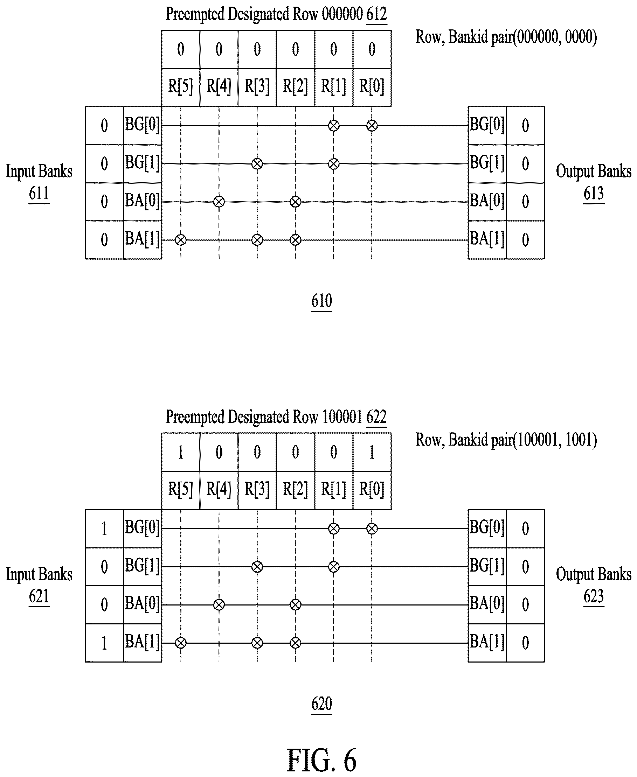

However, the table 510 may use, as PIM computation addresses, predetermined row addresses that satisfy some conditions among all available row addresses. A method of freely selecting more addresses during a computation by allowing all row addresses to be used is described in greater detail below with reference to FIGS. 5 and 6.

FIG. 6 illustrates an example method of designating, as a PIM computation address, a pair of a row address and a bank address corresponding to the row address according to one or more embodiments. The description provided with reference to FIG. 3 may also apply to FIG. 6.

Referring to FIG. 6, in a non-limiting example, a host processor (e.g., the host processor 311 of FIG. 3) may designate all row addresses as PIM computation addresses. However, the host processor may also store an input bank address suitable for a corresponding row address.

More particularly, a bank address of a PIM computation address is set as a predetermined target bank, and the host processor may calculate pairs of row bits suitable for the target bank address and bank bits corresponding to the row bits through a hash function and reserve the resulting pairs of row addresses and bank addresses.

In a case 610, the host processor may desire to obtain an output bank 613 of which bank addresses BG[0], BG[1], BA[0], and BA[1] all have 0 as a result of bank shuffling during a PIM operation. In this case, a row address 612 to be used may be Row Address 0(000000). The host processor may calculate a bank bit of an input bank 611 that may output the output bank 613 through a hash computation with the row address 612 Row Address 0 (000000), and in a case 610, the row address 612 may be selected from the addresses BG[0], BG[1], BA[0], and BA[1](0000) of the input bank 611 paired with Row Address 0 (000000).

Similarly, in a case 620, the host processor may desire to obtain an output bank 623 of which bank addresses BG[0], BG[1], BA[0], and BA[1] all have 0 as a result of bank shuffling during a PIM operation. In this case, a row address 622 to be used may be Row Address 1(100001). The host processor may calculate a bank bit of an input bank 621 that may output the output bank 623 through a hash computation with the row address 622 Row Address 1(100001), and in the case 620, the row address 622 may be selected from the addresses BG[0], BG[1], BA[0], and BA[1](1001) of the input bank 621 paired with Row Address 1(100001).

The host processor 311 may reserve a pair of a row address suitable for a target bank required for a PIM computation and a bank address to prepare for an efficient execution of a computation. Accordingly, the host processor may, in this manner, minimize an issue that may occur in bank shuffling.

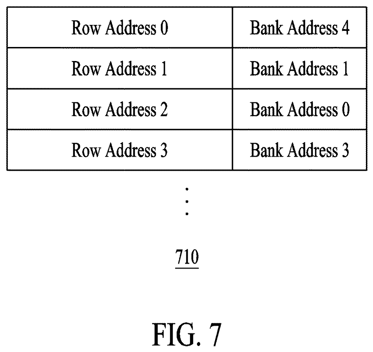

FIG. 7 illustrates an example method of storing pairs of row addresses and bank addresses in a table according to one or more embodiments. The description provided with reference to FIGS. 3 and 6 may also apply to FIG. 7.

Referring to FIG. 7, in a non-limiting example, a table 710 may pre-store (i.e., reserve) pairs of row addresses and bank addresses required for PIM computations. This table may be referenced as a lookup table when needed and utilized for computations. For example, (Row Address 0, Bank Address 4), (Row Address 1, Bank Address 1), (Row Address 2, Bank Address 0), and (Row Address 3, Bank Address 3) may be stored as PIM computation addresses in the table 710. A host processor (e.g., the host processor 311 of FIG. 3) may enhance efficiency in performing a PIM computation through pairs of row addresses and bank addresses stored in advance.

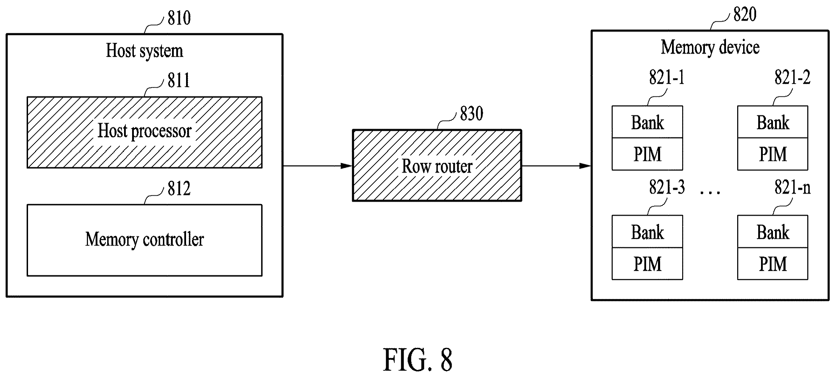

However, when the host processor determines a PIM computation address according to the method described above with reference to FIGS. 4 to 7, a large number of row addresses (or pairs of row addresses and bank addresses) may be needed to designate a PIM computation address. As described in greater detail below with reference to FIG. 8, a small number of predetermined PIM computation addresses may be allocated as designated memory addresses using a router and a PIM computation address. The PIM computation address may be an input memory address of a memory command and correspond to a designated memory address. The PIM computation addresses may be converted to redirected memory addresses (i.e., redirected row addresses) based on mapping information. Accordingly, a small number of predetermined PIM computation addresses may be used to perform a PIM computation.

FIG. 8 illustrates an example electronic device according to one or more embodiments. The description provided with reference to FIGS. 3 to 7 may also apply to FIG. 8.

Referring to FIG. 8, in a non-limiting example, an electronic device 800 may include a host system 810, a memory device 820, and a row router 830.

In an example, a host processor 811 may generate a memory address together with a memory request. The host processor 811 may transmit the generated memory request and the memory address to a memory controller 812. The host processor 811 may generate a predetermined number of PIM computation addresses as designated memory addresses. For example, the host processor 811 may determine, as designated memory addresses, some of the PIM computation addresses included in the table 510 as described above with reference to FIG. 5 and the table 710 described with reference to FIG. 7.

In an example, a designated memory address transmitted from the host system 810 may be converted into a redirected memory address through the row router 830, and the memory command may be transmitted to the memory device 820. Alternatively, depending on the example, the row router 830 may receive a designated memory address and a memory command, may convert the designated memory address into a redirected memory address, and may transmit the memory command to the memory device 820 without modification. In addition, the memory device 820 may include a plurality of pairs of memory banks and PIM blocks s 821-1, 821-2, 821-3, ..., 821-n.

In an example, the row router 830 may be a device for routing a memory address and may convert a received memory address into a different memory address. The row router 830 may include a routing register storing mapping information that maps each designated memory address to a redirected memory address. The designated memory address may represent a partial area of the memory device 820 and the redirected memory address may represent another partial area of the memory device 820. In other words, the designated memory address and the redirected memory address may represent different areas of the memory device 820.

The mapping information may be information that maps designated memory addresses one-to-one to redirected memory addresses, and for example, may be implemented as a routing table.

The row router 830 may include, based on the mapping information stored in the routing register, a selection processing element that converts an input memory address into a redirected memory address mapped onto a corresponding designated memory address. The selection processing element may include a circuit (e.g., a processor, an electrical circuit or a logical circuit) that selects one of the input signals, and may be implemented as, for example, a multiplexer (MUX), or a selector. However, the example is not limited thereto. The input memory address received by the row router 830 may be requested from the host processor 811 and may be a designated memory address included in a memory command generated by the memory controller 812. The row router 830 may receive, as an input memory address, the designated memory address transmitted from the memory controller 812 and may convert the input memory address into a redirected memory address. The memory command may be executed in the redirected memory address of the memory device 820 converted by the row router 830. In other words, a PIM operation corresponding to the memory command may be performed on the data of the converted redirected memory address.

Although FIG. 8 illustrates an example in which the row router 830 is provided separately from the host system 810 and the memory device 820, examples are not limited thereto. For example, the row router 830 may be included in the memory device 820 or the host system 810. Additionally, the electronic device 800 may include only a row router that is provided separately from the host system 810 and the memory device 820, may include a host system including a memory controller including a row router, or may include a memory device including a row router. In addition, the row router 830 may be included as a processing element or processors within the host system 810 and/or host processor 811.

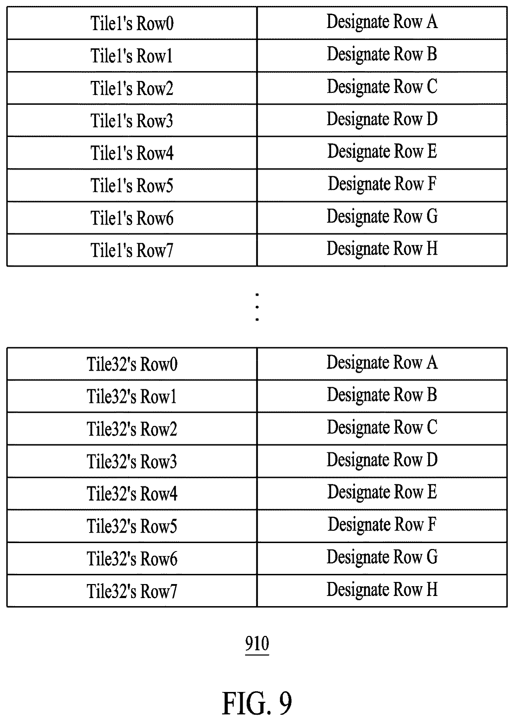

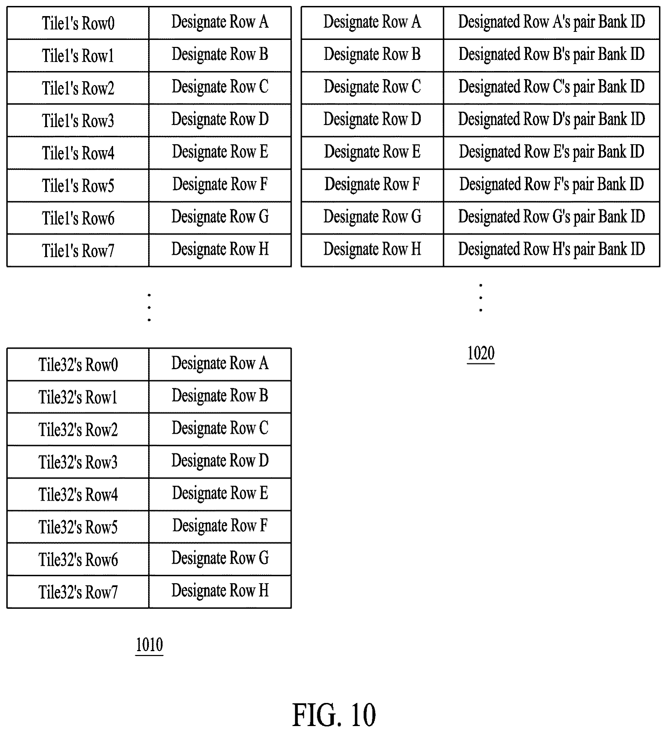

FIGS. 9 and 10 illustrate examples routing tables according to one or more embodiments. The description provided with reference to FIGS. 3 to 8 may also apply to FIG. 9.

Referring to FIG. 9, in a non-limiting example, mapping information may map respective predetermined designated memory addresses to redirected memory addresses. In the mapping information, the designated memory addresses may be mapped one-to-one to redirected memory addresses. For example, referring to a table 910, Row A to Row H, which are determined to be designated memory addresses in the mapping information, may be one-to-one mapped to Row 0 to Row 7 of a PIM tile 1, which are determined to be redirected memory addresses. A designated memory address of the routing table 910 may be selected from among PIM computation addresses set as row addresses. For example, the designated memory address of the routing table 910 may be selected from among the PIM computation addresses of the table 510 described above with reference to FIG. 5.

Each PIM tile may be mapped to a plurality of designated memory addresses according to designated memory addresses of the mapping information. For example, a row of each PIM tile may be mapped to designated memory addresses of Row A to Row H. The row of each PIM tile may represent a redirected memory address.

Redirected memory addresses corresponding to a PIM tile may be stored in the mapping information stored in a routing register. Redirected memory addresses corresponding to one PIM tile may be stored in the mapping information that is stored in the routing register. When all PIM operations are performed on a PIM tile, an electronic device may update the memory addresses stored in the mapping information with memory addresses for a next PIM tile. In other words, when a loop for a PIM operation of one PIM tile is completed, the electronic device may update the redirected memory addresses stored in the mapping information to the redirected memory addresses for the next PIM tile. For example, when all PIM operations are performed on a PIM tile 1, an electronic device may update the memory addresses stored in the mapping information to memory addresses for a PIM tile 2.

Although eight designated memory addresses and eight redirected memory addresses stored in the routing table 910 are illustrated in FIG. 9 for ease of description, examples are not limited thereto, and a plurality of designated memory addresses and a plurality of redirected memory addresses may be stored.

Referring to FIG. 10, in a non-limiting example, a designated memory address of a routing table 1010 may be selected from among PIM computation addresses set as pairs of row addresses and bank addresses in table 1020. For example, the designated memory address of the routing table 1010 may be selected from among the PIM computation addresses of the table 710 described above with reference to FIG. 7. Therefore, the routing table 1010 may include a table in which row addresses of PIM computation addresses are mapped to redirected memory addresses and a table in which bank addresses corresponding to row addresses of PIM computation addresses are mapped to redirected memory addresses.

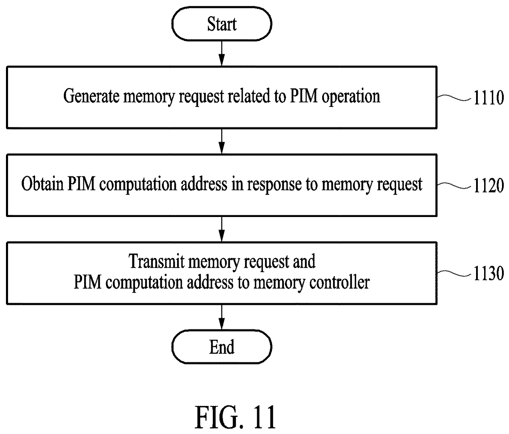

FIG. 11 illustrates an example method of operating an electronic device according to one or more embodiments.

In the following examples, operations may be performed sequentially but not necessarily. For example, the order of the operations may be changed, and at least two of the operations may be performed in parallel. Operations 1110 to 1130 may be performed by at least one component (e.g., the host processor, the memory controller, the row router, and the memory device) of an electronic device (e.g., electronic device 1200).

In an example, in operation 1110, the electronic device (e.g., electronic device 1200) may generate a memory request related to a PIM operation.

In an example, in operation 1120, in response to the memory request, the electronic device may obtain a PIM computation address. The PIM computation address may be a set of addresses shuffled to a preset target bank (hereinafter, when channel shuffling or rank shuffling is used as a memory address designation computation instead of bank shuffling, a preset target channel or a preset target rank may be used instead of a preset target bank) when a memory controller performs a memory address designation computation (hereinafter, for ease of description, a memory address designation computation is described based on bank shuffling. However, as described above, a memory address designation computation may include not only the bank shuffling but also various memory address designation methods such as channel shuffling and rank shuffling). The electronic device may obtain a PIM computation address based on a table in which the PIM computation address is stored. The table may store a row address from which a target bank is output when bank shuffling is performed.

Alternatively, the electronic device may calculate, based on a DRAM addressing hash function used in bank shuffling, the row address from which the target bank is output by performing the bank shuffling. The electronic device may calculate, based on a hash function used in the bank shuffling, a pair of the row address from which the target bank may be output and a bank address corresponding to the row address by performing the bank shuffling.

In operation 1110, the electronic device may transmit the memory request and the PIM computation address to the memory controller. The memory controller may change a bank address of the PIM computation address to a target bank by performing the bank shuffling and generate a memory command including the memory request and the PIM computation address changed through the bank shuffling.

The descriptions provided with reference to FIGS. 1 to 10 may apply to the operations shown in FIG. 11, and thus further detailed descriptions will be omitted.

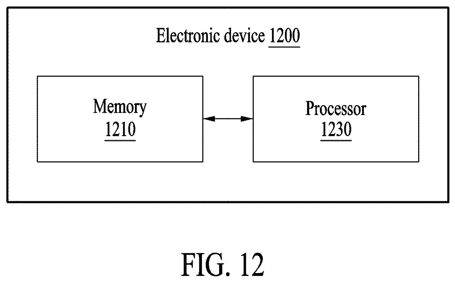

FIG. 12 illustrates an example electronic device according to one or more embodiments.

Referring to FIG. 12, in a non-limiting example, an electronic device 1200 may include a memory 1210 and a processor 1230.

The memory 1210 may include computer-readable instructions. The processor 1230 may be configured to execute computer-readable instructions, such as those stored in the memory 1210, and through execution of the computer-readable instructions, the processor 1230 is configured to perform one or more, or any combination, of the operations and/or methods described herein. The memory 1210 may be a volatile or nonvolatile memory.

The volatile memory device may be implemented as DRAM, static RAM (SRAM), thyristor RAM (T-RAM), zero capacitor RAM (Z-RAM), or twin transistor RAM (TTRAM).

The non-volatile memory device may be implemented as electrically erasable programmable read-only memory (EEPROM), flash memory, magnetic RAM (MRAM), spin-transfer torque (STT)-MRAM, conductive bridging RAM (CBRAM), ferroelectric RAM (FeRAM), phase change RAM (PRAM), resistive RAM (RRAM), nanotube RRAM, polymer RAM (PoRAM), nano floating gate Memory (NFGM), holographic memory, a molecular electronic memory device, or insulator resistance change memory.

The processor 1230 may be configured to execute programs or applications to configure the processor 1230 to control the electronic apparatus 1200 to perform one or more or all operations and/or methods involving PIM address computation and PIM address generation, and may include any one or a combination of two or more of, for example, a central processing unit (CPU), a graphic processing unit (GPU), a neural processing unit (NPU) and tensor processing units (TPUs), but is not limited to the above-described examples. The processor 1230 may include one or more processors and may be implemented as processing elements, systems, and controllers.

The processor 1230 may be a hardware-implemented data processing device having a circuit that is physically structured to execute desired operations. The desired operations may include, for example, code or instructions in a program.

The hardware-implemented data processing device may include, for example, a microprocessor, a CPU, a processor core, a multi-core processor, a multiprocessor, an application-specific integrated circuit (ASIC), and a field-programmable gate array (FPGA).

The processor 1230 may generate a memory request related to a PIM operation, obtain a PIM computation address in response to the memory request, and transmit the memory request and the PIM computation address to the memory controller. The processor 1230 may perform operations of the compression system described with reference to FIGS. 1A to 11 in substantially the same manner. Accordingly, a detailed description thereof is omitted.

The electronic devices, processors, processing elements, memories, memory devices, electronic device 300, host system 310, memory device 310, plurality of pairs of memory banks and PIM blocks 321-1, 321-2, 321-3, ..., 321-n, host processor 311, memory controller 312, memory device 320, electronic device 800, host system 810, host processor 811, memory device 820, row router 830, plurality of pairs of memory banks and PIM blocks 821-1, 821-2, 821-3, ..., 821-n, electronic device 1200, memory 1210, and processor 1230 described herein and disclosed herein described with respect to FIGS. 1-12 are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-12 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks , and/or any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims . The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the invention is defined by the enclosed claims.

## Claims

1. A processor-implemented method, the method comprising:
generating a memory request related to a processing-in-memory, PIM, operation;
obtaining a PIM computation address in response to the memory request;
transmitting, to a memory controller, the memory request and the PIM computation address; and
designating, by the memory controller, a memory address through bank shuffling,
wherein the bank shuffling maps the PIM computation address to a set of addresses shuffled to a preset target bank.

2. The method of claim 1, wherein the obtaining of the PIM computation address comprises:
obtaining the PIM computation address from a table storing the PIM computation address.

3. The method of claim 2, wherein the table stores a row address from which the target bank is output in response to the designating, or
wherein the table stores a pair of a row address, from which the target bank is output in response to the designating, and a bank address corresponding to the row address.

4. The method of one of claims 1 to 3, wherein the obtaining of the PIM computation address either comprises:
calculating a row address, based on a hash function used for the bank shuffling, from which the target bank is output by performing the bank shuffling, or
calculating a pair of a row address based on a dynamic random access memory, DRAM, addressing hash function used in the bank shuffling, from which the target bank is output, and a bank address corresponding to the row address by performing the bank shuffling.

5. The method of one of claims 1 to 4, further comprising:
changing, by the memory controller, a bank address of the PIM computation address to the target bank through the bank shuffling; and
generating a memory command comprising the PIM computation address changed through the bank shuffling and the memory request.

6. The method of claim 5, further comprising:
determining whether the changed PIM computation address comprised in the memory command corresponds to any one of predetermined designated memory addresses; and
in response to the changed PIM computation address corresponding to any one of the designated memory addresses, converting, based on mapping information stored in a routing register, the changed PIM computation address to a redirected memory address mapped to the corresponding designated memory address.

7. The method of claim 6, wherein the mapping information maps each of the designated memory addresses representing a partial region of a memory to a redirected memory address representing another partial region of the memory, and
wherein the memory command is executed in the converted redirected memory address.

8. The method of claim 7, wherein, in response to PIM operations for a target PIM tile corresponding to the converted redirected memory address being performed, a plurality of redirected memory addresses stored in the routing register is updated to a plurality of redirected memory addresses corresponding to a PIM tile subsequent to the target PIM tile.

9. The method of one of claims 1 to 8, wherein the bank shuffling comprises:
shuffling of one of a bank or a channel.

10. An electronic device, comprising:
processors configured to execute instructions; and
a memory storing the instructions, wherein execution of the instructions configures the processors to:
generate a memory request related to a processing-in-memory, PIM, operation;
obtain a PIM computation address in response to the memory request;
transmit, to a memory controller, the memory request and the PIM computation address; and
designate, by the memory controller, a memory address through bank shuffling,
wherein the bank shuffling maps the PIM computation address to a set of addresses shuffled to a preset target bank.

11. The electronic device of claim 10, wherein the processor is further configured to:
obtain the PIM computation address from a table storing the PIM computation address.

12. The electronic device of claim 11, wherein the table stores a row address from which the target bank is output in response to the designating, or
wherein the table stores a pair of a row address, from which the target bank is output in response to the designating, and a bank address corresponding to the row address.

13. The electronic device of claim 10 or 11, wherein the processor is further configured to:
calculate a row address, based on a hash function used for the bank shuffling, from which the target bank is output by performing the bank shuffling, or
calculate a pair of a row address, based on a dynamic random access memory, DRAM, addressing hash function used in the bank shuffling, from which the target bank is output by performing the bank shuffling, and a bank address corresponding to the row address.

14. The electronic device of one of claims 10 to 13, wherein the memory controller is configured to:
change a bank address of the PIM computation address to the target bank by performing the bank shuffling: and
generate a memory command comprising the PIM computation address changed through the bank shuffling and the memory request.

15. The electronic device of claim 14, wherein the processor is further configured to:
determine whether the changed PIM computation address comprised in the memory command corresponds to any one of preset designated memory addresses; and
in response to the changed PIM computation address corresponding to any one of the designated memory addresses, convert, based on mapping information stored in a routing register, the changed PIM computation address to a redirected memory address mapped to the corresponding designated memory address,
wherein the mapping information preferably maps each of the designated memory addresses representing a partial region of a memory to a redirected memory address representing another partial region of the memory, and
wherein the memory command is preferably executed in the converted redirected memory address.
